(19) **Europäisches Patentamt**

**European Patent Office**

**Office européen des brevets**

(11) **EP 1 715 583 A2**

(12) **EUROPÄISCHE PATENTANMELDUNG**

(43) Veröffentlichungstag:
25.10.2006 Patentblatt 2006/43

(51) Int Cl.:
*H03K 17/16* (2006.01)  *G05F 1/573* (2006.01)

(21) Anmeldenummer: 06007541.3

(22) Anmeldetag: 10.04.2006

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **11.04.2005 DE 102005016748**

(71) Anmelder: **Micronas GmbH**
**79108 Freiburg i. Br. (DE)**

(72) Erfinder:
• **Bauer, Achim**
**9500 Villach (AT)**
• **Niederfriniger, Thomas**
**9500 Villach (AT)**

(74) Vertreter: **Göhring, Robert**
**Westphal - Mussgnug & Partner**
**Patentanwälte**
**Am Riettor 5**
**78048 Villingen-Schwenningen (DE)**

(54) **Regelschaltung und Verfahren zum Ansteuern eines Feldeffektschalttransistors**

(57)     Die Erfindung betrifft eine Regelschaltung (1) für einen eine Source (S6), ein Drain (D6), ein zugeordnetes Gate (G6) und einen die Source (S6) und das Drain (D6) verbindenden Kanal (K) aufweisenden Feldeffektschalttransistor (T6) sowie ein Verfahren zum Ansteuern des Feldeffektschalttransistors (T6), mit der bzw. mit dem der Kanalwiderstand (Ron) des Feldeffektschalttransistors (T6) in einem Durchlassbetrieb (on) auf einen im wesentlichen konstanten Widerstandswert regelbar ist bzw. geregelt wird. Erfindungsgemäß ist vorgesehen, die Gate-Source-Spannung des Feldeffektschalttransistors (T6) in dem Durchlassbetrieb (on) lediglich dann auf einen im wesentlichen konstanten Spannungswert (Vdd-King) zu regeln, wenn die Kanalspannung (Kin) innerhalb eines vorgegebenen Kanalspannungsintervalls (0 ≤ Kin, Kout ≤ 1,5 Volt) liegt. Alternativ oder zusätzlich ist vorgesehen die Gate-Source-Spannung des Feldeffektschalttransistors (T6) in dem Durchlassbetrieb (on) auf einen Spannungswert zu regeln, welcher lediglich um einen vorgegebenen Bruchteil (C22/(C21+C22) der Kanalspannung (Kin, Kout) schwankt. Hierfür werden entsprechende Schaltungsanordnungen vorgeschlagen.

Fig. 1

EP 1 715 583 A2

**EP 1 715 583 A2**

## Beschreibung

Die Erfindung betrifft eine Regelschaltung für einen eine Source, ein Drain, ein zugeordnetes Gate und einen die Source und das Drain verbindenden Kanal aufweisenden Feldeffektschalttransistor sowie ein Verfahren zum Ansteuern des Feldeffektschalttransistors, mit der bzw. mit dem der Kanalwiderstand des Feldeffektschalttransistors in einem Durchlassbetrieb auf einen im wesentlichen konstanten Widerstandswert regelbar ist bzw. geregelt wird.

Aus dem Aufsatz "A 1.5-V, 10-bit, 14.3MS/s Pipeline Analog-to-Digital Converter" von Andrew M. Abo und Paul R. Gray in IEEE Journal of Solid State Circuits, Vol. 34, No. 5, May 1999, Seiten 599-666 ist ein unter dem Namen Gate-Boosting bekanntes Verfahren und eine entsprechende Schaltungsanordnung beschrieben mittels dem bzw. mittels der die Potentialdifferenz zwischen Gate- und Kanalspannung, d.h. die Gate-Source-Spannung, im leitenden Fall über eine geschaltete Kondensatorstruktur konstant gehalten wird. Obwohl sich eine derartige Schaltungsanordnung bzw. ein derartiges Gate-Boosting-Verfahren dem Grunde nach bewährt hat, weist sie doch einige Nachteile auf. Insbesondere ist der Flächenverbrauch einer derartigen Schaltungsanordnung auf einem Chip aufgrund des kapazitiven Elements und der Transistoren in der erforderlichen Nachladeschaltung vergleichsweise hoch. Darüber hinaus erfordert ein derartiger geboosteter Schalter eine Nachladung, was insbesondere bei statischem Betrieb (Schaltvorgänge selten, dauerhaft "an" oder dauerhaft "aus") das übertragene Signal stört. Durch den Ladetakt selbst kann es zu Ladungseinkopplungen in den Signalpfad kommen. Schließlich wurde festgestellt, dass Transistorschalter, welche mit einem Gate-Boosting-Verfahren betrieben werden, eine Neigung zur Selbstzerstörung in bestimmten Betriebszuständen aufweisen.

Aus der US 6,492,860 B1 ist zum Beispiel bekannt, zum Schalten von Signalen ein sogenanntes Transmission-Gate bestehend aus parallel geschalteten NMOS- und PMOS-Transistoren zu verwenden. Damit ist eine vergleichsweise hohe Durchlassleitfähigkeit über den gesamten Versorgungsspannungsbereich gegeben. Es tritt jedoch eine vergleichsweise ausgeprägte Variation des Kanalwiderstandes in Abhängigkeit von der Kanalspannung auf. Diese Kanalwiderstandsänderung führt zu Verzerrungen des durchgeleiteten Signals, die unter der englischen Bezeichnung "Harmonic Distortion" bekannt sind.

Die Aufgabe der Erfindung wird nunmehr darin gesehen, eine Regelschaltung sowie ein Verfahren bereitzustellen, welche bzw. welches die oben genannten Nachteile nicht mehr aufweist oder bei der bzw. bei dem diese Nachteile zumindest deutlich reduziert sind. Insbesondere soll eine Regelschaltung sowie ein Verfahren vorgestellt werden, mittels der bzw. mit Hilfe dessen der Schalttransistor über seinem maßgeblichen Betriebsspannungsbereich einen vergleichsweise konstanten Kanaldurchlasswiderstand aufweist und wobei während seines regulären Betriebs eine Zerstörung nicht oder zumindest in deutlich geringerem Maß auftritt.

Diese Aufgabe wird durch eine Regelschaltung mit den Merkmalen des Patentanspruchs 1 sowie ein Verfahren mit den Merkmalen des Patentanspruchs 9 gelöst. Vorteilhafte Ausführungen und Weiterbildungen der Erfindung sind in den Unteransprüchen angegeben.

Die Erfindung basiert auf der Erkenntnis, dass eine Zerstörung des Schalttransistors beim Gate-Boosting-Verfahren insbesondere dann auftritt, wenn die Spannung des durch den Schalttransistor durchgeleiteten Signals vergleichsweise hoch ist, da dann die additive Überlagerung der Kanalspannung und der Kondensatorspannung am Gate den zulässigen Grenzwert für die Gate-Spannung übersteigt. Die Erfindung basiert nunmehr auf der Idee, diese Überspannung entweder zu begrenzen oder zumindest gegenüber dem herkömmlichen Gate-Boosting Verfahren zu reduzieren.

Betrachten wir nachfolgend zunächst den Fall der Begrenzung der Überspannung:

Ausgehend von einer Regelschaltung bzw. einem Verfahren zum Ansteuern eines Feldeffektschalttransistors üblicher Art mit Source, Drain, Gate und einem Source und Drain verbindenden Kanal, mit welcher bzw. mit welchem der Kanalwiderstand des Feldeffektschalttransistors in einem Durchlassbetrieb auf einen im wesentlichen konstanten Widerstandswert regelbar ist bzw. geregelt wird, ist erfindungsgemäß vorgesehen die Gate-Source-Spannung des Feldeffektschalttransistors in einem Durchlassbetrieb lediglich dann auf einen im wesentlichen konstanten Spannungswert zu regeln, wenn die Kanalspannung innerhalb eines vorgegebenen, nachfolgend als "applikatives Kanalspannungsintervall" bezeichneten, Kanalspannungsintervalls liegt. Anstelle einer kanalspannungsunabhängigen Nachführung der Gatespannung mit der Kanalspannung (wie dies beim Gate-Boosting der Fall ist) findet folglich lediglich eine Nachführung statt soweit die Kanalspannung einen vorgegebenen Grenzwert nicht überschreitet. Überschreitet die Kanalspannung jedoch diesen Grenzwert findet keine Nachführung der Gatespannung mit der Kanalspannung mehr statt. Es ist vorgesehen, dass die Gatespannung dann nicht mehr weiter ansteigt, so dass die Überspannung auf einen betriebssicheren Wert begrenzt ist und damit eine Zerstörung des Schalttransistors bei geeigneter Wahl des Grenzwerts für die Kanalspannung zuverlässig verhindert ist.

Die Regelschaltung umfasst zu diesem Zweck eine erste Schaltungsanordnung, um die Gate-Source-Spannung des Feldeffektschalttransistors in dem Durchlassbetrieb lediglich dann auf einen im wesentlichen konstanten Spannungswert zu regeln, wenn die Kanalspannung innerhalb eines vorgegebenen Kanalspannungsintervalls liegt.

Wie oben bereits dargelegt wurde, kann eine Zerstörung des Schalttransistors nicht nur dadurch verhindert werden, indem die Überspannung am Gate auf einen unkritischen Grenzwert begrenzt wird, sondern auch dann, wenn die Überspannung gegenüber dem herkömmlichen Boosting-Verfahren reduziert wird. Dies ist insbesondere dann zu erreichen, wenn sich die Gate-Spannung des Feldeffektschalttransistors in dem Durchlassbetrieb nicht in gleichem Maße ändert wie die Kanalspannung, sondern wenn die Gate-Spannung sich nur um einen vorgegebenen Bruchteil der Kanalspannung (Bruchteil < 1) ändert. Die Nachregelung der Gate-Spannung erfolgt also nicht in vollem zur Gewährleistung eines exakt konstanten von der Kanalspannung unabhängigen Kanalwiderstand erforderlichen Ausmaß. Eine teilweise Nachregelung reicht jedoch für viele Anwendungen aus, um einen über dem üblichen Betriebsspannungsintervall hinreichend konstanten Kanalwiderstand bereitzustellen.

Alternativ oder zusätzlich zu der vorstehend angegebenen ersten (die Überspannung begrenzenden) Schaltungsanordnung weist die erfindungsgemäße Regelschaltung eine zweite (die Überspannung reduzierende) Schaltungsanordnung auf, um die Gate-Source-Spannung des Feldeffektschalttransistors im Durchlassbetrieb auf einen Spannungswert zu regeln, welcher sich lediglich um einen vorgegebenen Bruchteil der Kanalspannung ändert.

Die erste (die Überspannung begrenzende) Schaltungsanordnung lässt sich am einfachsten mit Hilfe einer spannungsabhängigen Spannungsteilerschaltung realisieren. Dieser Spannungsteilerschaltung wird eingangsseitig die Kanalspannung oder eine von der Kanalspannung abgeleitete Spannung zugeführt. Die der Spannungsteilerschaltung zugeführte Spannung beeinflusst das Teilungsverhältnis des vorzugsweise (resistiven) Transistorspannungsteilers derart, dass ausgehend von einer die Spannungsteilerschaltung speisenden Betriebsspannung ausgangsseitig eine geteilte Spannung entsteht, welche dem gewünschten Kennlinienverlauf folgt. Diese resultierende geteilte Spannung wird dem Gate des anzusteuernden Feldeffektschalttransistors zugeführt.

Um zu verhindern, dass das Nutzsignal, nämlich das Kanalspannungssignal, durch die Ansteuerung der Spannungsteilerschaltung (merklich) gedämpft wird, umfasst die erste Schaltungsanordnung erfindungsgemäß vorzugsweise eine Spannungsfolgerschaltung, z.B. einen Sourcefolger, welcher eingangsseitig die Kanalspannung zugeführt wird. Am Ausgang der Spannungsfolgerschaltung wird ein Signal ausgegeben, welches im wesentlichen der eingangsseitig zugeführten Kanalspannung folgt. Dieses Ausgangssignal dient nunmehr erfindungsgemäß als Steuersignal, um das Teilungsverhältnis der Spannungsteilerschaltung entsprechend der obigen Vorgabe einzustellen.

Die erfindungsgemäße Regelschaltung mit Spannungsfolgerschaltung und Spannungsteilerschaltung lässt sich zur Ansteuerung eines Feldeffektschalttransistors in Form eines n-Kanal Feldeffekttransistors vom Anreicherungstyp beispielsweise wie folgt realisieren:

Die Spannungsfolgerschaltung umfasst einen ersten p-Kanal Feldeffekttransistor vom Anreicherungstyp mit Gate, Source und Drain. Es ist ein zweiter p-Kanal Feldeffekttransistor vom Anreicherungstyp mit Gate, Source und Drain vorgesehen, welcher als Stromquelle dient. Die Spannungsteilerschaltung umfasst einen dritten p-Kanal Feldeffekttransistor vom Anreicherungstyp mit je einem Gate-, Source- und Drain-Anschluss sowie einen ersten n-Kanal Feldeffekttransistor vom Anreicherungstyp mit je einem Gate-, einem Source- und einem Drain-Anschluss.

Schließlich ist ein zweiter n-Kanal Feldeffekttransistor vom Anreicherungstyp mit einem Gate, einer Source und einem Drain vorgesehen, welcher zum Umschalten des Feldeffektschalttransistors vom leitenden in den nichtleitenden Zustand und umgekehrt dient.

Die oben angegebenen Feldeffekttransistoren sind in der nachfolgend beschriebenen Weise miteinander verschaltet:

Das Gate des ersten p-Kanal Feldeffekttransistors ist mit dem Kanal, insbesondere dem Source-Anschluss oder dem Drain-Anschluss, des Feldeffektschalttransistors verbunden. Der Source-Anschluss des ersten p-Kanal Feldeffekttransistors, der Drain-Anschluss des zweiten p-Kanal Feldeffekttransistors, der Drain-Anschluss des ersten n-Kanal Feldeffekttransistors und der Source-Anschluss des zweiten n-Kanal Feldeffekttransistors sind miteinander verbunden. Das Drain des dritten p-Kanal Feldeffekttransistors und die Source des ersten n-Kanal Feldeffekttransistors sind mit dem Gate des Feldeffektschalttransistors verbunden. Die Source des zweiten p-Kanal Feldeffekttransistors, die Source des dritten p-Kanal Feldeffekttransistors und das Gate des ersten n-Kanal-Feldeffekttransistors sind mit einem (positiven) Betriebspotential verbunden. Das Drain des ersten p-Kanal Feldeffekttransistors und das Drain des zweiten n-Kanal-Feldeffekttransistors sind mit einem Bezugspotential, z.B. Masse, verbunden. Das Gate des zweiten p-Kanal Feldeffekttransistors, das Gate des dritten p-Kanal Feldeffekttransistors und das Gate des zweiten n-Kanal-Feldeffekttransistors sind mit einem Eingang verbunden, welchem eine Schaltspannung zuführbar ist, um den Feldeffektschalttransistor in den leitenden oder sperrenden Betriebszustand zu versetzen.

Die Wirkungsweise der Nachregelung der Gatespannung im leitenden Betriebszustand des Feldeffektschalttransistors für ein begrenztes Kanalspannungsintervall kann wie folgt qualitativ beschrieben werden:

Geht man von einer vergleichsweise kleinen Kanalspannung aus, so stellt sich zunächst eine im Wesentlichen durch Geometrie und Dotierung der Transistoren des Spannungsteilers bestimmte Gatespannung ein. Mit steigender Kanalspannung folgt die Spannung am Sourcefolger der Kanalspannung um die Schwellspannung des Sourcefolgertransistors versetzt. Über den Transistorteiler lässt sich also ein adaptives Teilungsverhältnis realisieren. Die passende Adaption des Teilerverhältnisses kommt dadurch zustande, dass die Kanalleitfähigkeit der beiden Transistoren des Transistorteilers über die Änderung der jeweiligen Kanalspannungen moduliert wird. So nimmt z.B. die Kanalleitfähigkeit des ersten n-Kanal Feldeffekttransistors mit steigender Ausgangsspannung des Sourcefolgers ab, während die Kanalleitfähigkeit des dritten p-Kanal Feldeffekttransistors in ähnlicher Weise zunimmt. Die Nachführung der Gatespannung sättigt aufgrund des endlichen Werts der Betriebsspannung, wenn sich die Potentialdifferenz zwischen Gate und Kanal des ersten n-Kanal Feldeffekttransistors dessen Schwellspannung annähert.

Wird anstelle eines n-Kanal-Feldeffektschalttransistors ein p-Kanal-Feldeffektschalttransistor verwendet, so erhält man eine erfindungsgemäße Regelschaltung in komplementärer Weise, wenn man die Betriebspotential- und Bezugspotentialanschlüsse vertauscht und wenn man p-Kanal-Feldeffekttransistoren durch n-Kanal-Feldeffekttransistoren ersetzt und umgekehrt:

Die entsprechende Spannungsfolgerschaltung umfasst demgemäß einen ersten n-Kanal Feldeffekttransistor vom Anreicherungstyp mit einem Gate, einer Source und einem Drain. Es ist ein zweiter n-Kanal Feldeffekttransistor vom Anreicherungstyp mit einem Gate, einer Source und einem Drain als Stromquelle vorgesehen. Die Spannungsteilerschaltung umfasst einen dritten n-Kanal Feldeffekttransistor vom Anreicherungstyp mit einem Gate, einer Source und einem Drain sowie einen ersten p-Kanal Feldeffekttransistor vom Anreicherungstyp mit einem Gate, einer Source und einem Drain. Als Umschalttransistor ist ein zweiter p-Kanal Feldeffekttransistor vom Anreicherungstyp mit einem Gate, einer Source und einem Drain vorgesehen.

Die einzelnen Transistoren sind wie folgt verschaltet:

Das Gate des ersten n-Kanal Feldeffekttransistors ist mit dem Kanal, insbesondere der Source oder dem Drain, des Feldeffektschalttransistors verbunden. Die Source des ersten n-Kanal Feldeffekttransistors, das Drain des zweiten n-Kanal Feldeffekttransistors, das Drain des ersten p-Kanal Feldeffekttransistors und die Source des zweiten p-Kanal Feldeffekttransistors sind miteinander verbunden. Das Drain des dritten n-Kanal Feldeffekttransistors und die Source des ersten p-Kanal Feldeffekttransistors sind mit dem Gate des Feldeffektschalttransistor verbunden. Die Source des zweiten n-Kanal Feldeffekttransistors, die Source des dritten n-Kanal Feldeffekttransistors und das Gate des ersten p-Kanal-Feldeffekttransistors sind mit einem Bezugspotential verbunden. Das Drain des ersten n-Kanal Feldeffekttransistors und das Drain des zweiten p-Kanal-Feldeffekttransistors sind mit einem Betriebspotential verbunden und das Gate des zweiten n-Kanal Feldeffekttransistors, das Gate des dritten n-Kanal Feldeffekttransistors und das Gate des zweiten p-Kanal-Feldeffekttransistors sind mit einem Eingang verbunden, welchem eine Schaltspannung zum Schalten des Feldeffektschalttransistors zuführbar ist.

Die zweite Schaltungsanordnung der Regelschaltung lässt sich beispielhaft gemäß der Erfindung - abhängig von der Art des verwendeten Feldeffektschalttransistors - am einfachsten wie folgt realisieren:

1. Beispiel: Feldeffektschalttransistor in Form eines n-Kanal Feldeffekttransistors vom Anreicherungstyp:

Die zweite (die Überspannung reduzierende) Schaltungsanordnung umfasst z.B. einen p-Kanal Feldeffekttransistor vom Anreicherungstyp mit einem Gate, einer Source und einem Drain, einen n-Kanal Feldeffekttransistor vom Anreicherungstyp mit einem Gate, einer Source und einem Drain, einen ersten Kondensator und/oder einen zweiten Kondensator sowie einen weiteren Kondensator.

Diese Bauteile der zweiten Schaltungsanordnung sind wie folgt miteinander verschaltet:

Der Kanal des Feldeffektschalttransistors ist über den mit der Source des Feldeffektschalttransistors verbundenen ersten Kondensator mit dem Drain des p-Kanal Feldeffekttransistors, mit der Source des n-Kanal Feldeffekttransistors und mit dem Gate des Feldeffektschalttransistors verbunden. Alternativ oder zusätzlich ist der Kanal des Feldeffektschalttransistors über den mit dem Drain des Feldeffektschalttransistors verbundenen zweiten Kondensator mit dem Drain des p-Kanal Feldeffekttransistors, mit der Source des n-Kanal Feldeffekttransistors und mit dem Gate des Feldeffektschalttransistors verbunden. Das Drain des p-Kanal Feldeffekttransistors, die Source des n-Kanal Feldeffekttransistors und das Gate des Feldeffektschalttransistors sind über den weiteren Kondensator mit einem Bezugspotential verbunden. Die Source des p-Kanal Feldeffekttransistors ist mit einem (gegenüber dem Bezugspotential positiveren bzw. höheren) Betriebspotential verbunden. Das Drain des n-Kanal Feldeffekttransistors ist mit dem o.a. Bezugspotential verbunden und das Gate des p-Kanal Feldeffekttransistors und das Gate des n-Kanal Feldeffekttransistors sind mit einem Eingang verbunden, welchem eine Schaltspannung zum Schalten des Feldeffektschalttransistors zuführbar ist.

Die gesamte zweite Schaltungsanordnung entspricht also einer Modifikation der ersten Schaltungsanordnung dahingehend, dass die Nachregelung über den Sourcefolgertransistor und den resistiven Transistorteiler mit dem dritten p-Kanal Feldeffekttransistor und dem ersten n-Kanal Feldeffekttransistor vollständig entfällt und der erste n-Kanal Feldeffekttransistor durch einen Kurzschluss ersetzt wird.

Das Gate des Feldeffektschalttransistors wird bei dieser Modifikation nunmehr gleichspannungsmäßig hochohmig über den (dritten) p-Kanal Feldeffekttransistor vom Betriebspotential getrieben und wechselspannungsmäßig über den kapazitiven Teiler bestehend aus dem ersten und dem weiteren Kondensator und/oder dem zweiten und dem weiteren Kondensator. Der erste/zweite Kondensator kann als eigenständiges kapazitives Bauteil ausgeführt sein, es ist jedoch auch möglich, dass diese(r) allein durch die parasitäre Gate-Kanal-Kapazität des Feldeffektschalttransistors gegeben ist. Der weitere Kondensator muss demgegenüber in aller Regel als separates Bauteil ausgeführt sein.

Im leitenden Fall des Feldeffektschalttransistors ergeben sich Gleichspannungs- und Wechselspannungs-Anteil der Gatespannung aufgrund der kapazitiven Teilung aus der Summe aus Betriebsspannung (Differenz zwischen Betriebspotential und Bezugspotential) und dem Bruchteil der Kanalspannung, welcher sich aus dem Teilerverhältnis der oben angegebenen Kapazitäten ergibt. So wird zum Beispiel bei nahezu identischen Kapazitäten (genauer: die Summenkapazität aus erstem und zweitem Kondensator und die Kapazität des weiteren Kondensators sind identisch) eine Spannungsänderung im Kanal zur Hälfte am Gate des Feldeffektschalttransistors nachgeregelt. Die Spannungsschwankung am Gate ist damit halbiert.

2. Beispiel: Feldeffektschalttransistor in Form eines p-Kanal Feldeffekttransistors vom Anreicherungstyp:

Zu diesem Ausführungsbeispiel gelangt man, indem man entsprechend obiger Ausführung die zweite Schaltungsanordnung in komplementärer Weise ausführt. Insbesondere wird anstelle des n-Kanal Feldeffekttransistors ein p-Kanal Feldeffekttransistor eingesetzt umgekehrt. Außerdem sind Betriebspotential und Bezugspotential zu vertauschen.

Die zweite Schaltungsanordnung umfasst demnach einen n-Kanal Feldeffekttransistor vom Anreicherungstyp mit einem Gate, einer Source und einem Drain, einen p-Kanal Feldeffekttransistor vom Anreicherungstyp mit einem Gate, einer Source und einem Drain, einen ersten Kondensator und/oder einen zweiten Kondensator sowie einen weiteren Kondensator. Der Kanal des Feldeffektschalttransistors ist über den mit der Source des Feldeffektschalttransistors verbundenen ersten Kondensator mit dem Drain des n-Kanal Feldeffekttransistors, der Source des p-Kanal Feldeffekttransistors und mit dem Gate des Feldeffektschalttransistors verbunden. Alternativ oder zusätzlich ist der Kanal des Feldeffektschalttransistors über den mit dem Drain des Feldeffektschalttransistors verbundenen zweiten Kondensator mit dem Drain des n-Kanal Feldeffekttransistors, der Source des p-Kanal Feldeffekttransistors und mit dem Gate des Feldeffektschalttransistors verbunden. Das Drain des n-Kanal Feldeffekttransistors, die Source des p-Kanal Feldeffekttransistors und das Gate des Feldeffektschalttransistors sind über den weiteren Kondensator mit einem Betriebspotential verbunden. Die Source des n-Kanal Feldeffekttransistors ist mit einem Bezugspotential verbunden. Das Drain des p-Kanal Feldeffekttransistors ist mit dem Betriebspotential verbunden. Das Gate des n-Kanal Feldeffekttransistors und das Gate des p-Kanal Feldeffekttransistors sind mit einem Eingang verbunden, welchem eine Schaltspannung zum Schalten des Feldeffektschalttransistor zuführbar ist.

Bei vielen Anwendungen ist es unüblich lediglich einen Schalttransistor vorzusehen. Häufig wird das Schalten eines (digitalen oder analogen) Spannungssignals mit Hilfe eines sogenannten Transmission Gates durchgeführt. Ein derartiges Transmission Gate umfasst in der einfachsten Ausführung ein komplementäres Feldeffekttransistorenpaar, deren jeweilige Drainanschlüsse und deren jeweilige Sourceanschlüsse miteinander verbunden sind. Es können jedoch auch mehrere komplementäre Feldeffekttransistorenpaare hintereinandergeschaltet sein, was eine Rückkopplung des Kanaleingangs auf den Kanalausgang und umgekehrt verhindert.

Eine Regelschaltung für ein Transmission Gate mit einem eine Source, ein Drain, ein zugeordnetes Gate und einen die Source und das Drain verbindenden Kanal aufweisenden n-Kanal Feldeffektschalttransistor und einem eine Source, ein Drain, ein zugeordnetes Gate und einen die Source und das Drain verbindenden Kanal aufweisenden p-Kanal Feldeffektschalttransistor, bei dem die Source des n-Kanal Feldeffektschalttransistors und die Source des p-Kanal Feldeffektschalttransistors miteinander verbunden sind und bei dem das Drain des n-Kanal Feldeffektschalttransistors und das Drain des p-Kanal Feldeffektschalttransistors miteinander verbunden sind lässt sich aus den vorstehend beschriebenen Schaltungsanordnungen in einfacher Weise realisieren. Es kann nur eine erste Schaltungsanordnung für den n-Kanal Feldeffektschalttransistor oder den p-Kanal Feldeffektschalttransistor vorgesehen sein. Es kann alternativ auch nur eine zweite Schaltungsanordnung für den n-Kanal Feldeffektschalttransistor oder den p-Kanal Feldeffektschalttransistor vorgesehen sein. Weiterhin ist es möglich, dass sowohl der n-Kanal Feldeffektschalttransistor als auch der p-Kanal Feldeffektschalttransistor mit einer ersten oder einer zweiten Schaltungsanordnung der oben beschriebenen Art beschaltet ist. Es ist möglich, den n-Kanal Feldeffektschalttransistor mit einer ersten Schaltungsanordnung zu betreiben und den p-Kanal Feldeffektschalttransistor mit einer zweiten Schaltungsanordnung oder umgekehrt. Weiterhin kann auch vorgesehen sein, einen oder beide Schalttransistoren sowohl über die erste Schaltungsanordnung als auch die zweite Schaltungsanordnung zu betreiben. Es ist möglich, die entsprechenden Schaltungsanordnungen wahlweise zuschaltbar und wieder abschaltbar auszubilden.

Sämtliche oben angegebenen Ausführungsbeispiele zeichnen sich durch ein geringen Flächenverbrauch der Regelschaltung aus, da sämtliche Transistoren mit annährend minimalen Geometrien realisiert werden können.

Bei der Ausführungsvariante mit resistivem Transistorteiler erfolgt keine aktive Erzeugung einer Überspannung. Damit verbundene Komplikationen treten nicht auf. Bei Verwendung eines passiven kapazitiven Teilers resultiert eine durch das Kapazitätsverhältnis begrenzte Überspannung.

Bei den Schaltvorgängen können Ladungseinkopplungen durch die komplementäre Beschaltung eines Transmission-Gates mit Transistoren gleicher Fläche minimiert werden. Bei statischem Betrieb findet im Gegensatz zum Gate-Boosting keine Nachladung statt und damit einhergehende Störwirkungen sind ausgeschlossen.

Durch ein Nachführen der Gate-Spannung mit der Kanalspannung wird die Variation des Kanalwiderstandes und damit die Verzerrungen der Kanalspannung wesentlich reduziert.

Die Erfindung wird nunmehr anhand der Zeichnungen näher beschreiben. Es zeigen:

Fig. 1 ein Schaltbild eines ersten Ausführungsbeispiels einer erfindungsgemäßen Regelschaltung für die Gate-Spannung eines Schalttransistors im Form eines n-Kanal-MOSFET vom Anreicherungstyp

Fig. 2 ein Schaltbild eines zweiten Ausführungsbeispiels einer erfindungsgemäßen Regelschaltung für die Gate-Spannung eines Schalttransistors in Form eines p-Kanal-MOSFET vom Anreicherungstyp

Fig. 3 ein Schaltbild einer Schalttransistoranordnung in Form eines Transmission-Gates mit einem p-Kanal-MOSFET / n-Kanal-MOSFET-Paar und deren Beschaltung mit den Regelschaltungen nach den Figuren 1 und 2

Fig. 4 eine Simulation des Regelverhaltens einer erfindungsgemäßen Regelschaltung für die Gate-Spannung eines Schalttransistors in Form eines n-Kanal-MOSFET vom Anreicherungstyp. Aufgetragen ist die Gatespannung des Schalttransistors über dessen Kanaleingangsspannung

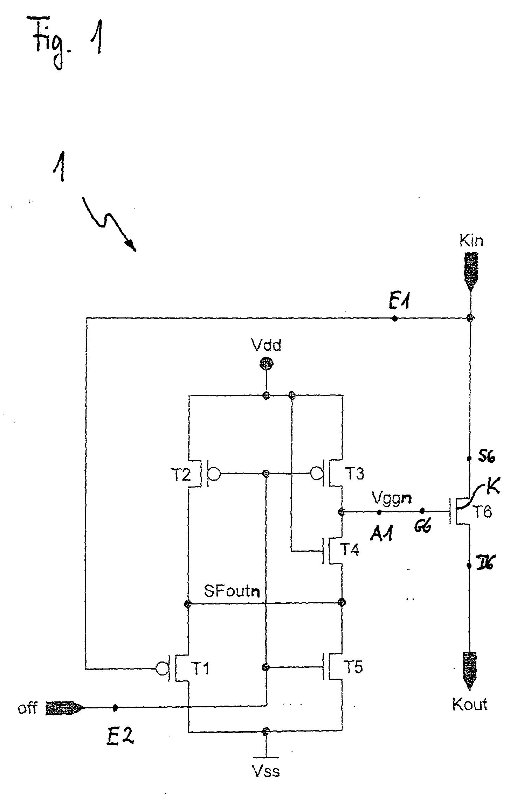

a) bei idealer Nachregelung,
b) bei tatsächlicher Nachregelung mit Hilfe der Regelschaltung nach der Fig. 1

Fig. 5 eine Simulation des Durchlasskanalwiderstandes einer Schalttransistoranordnung in Form eines Transmission-Gates mit einem p-Kanal-MOSFET / n-Kanal-MOSFET-Paar in Abhängigkeit von der Kanalspannung

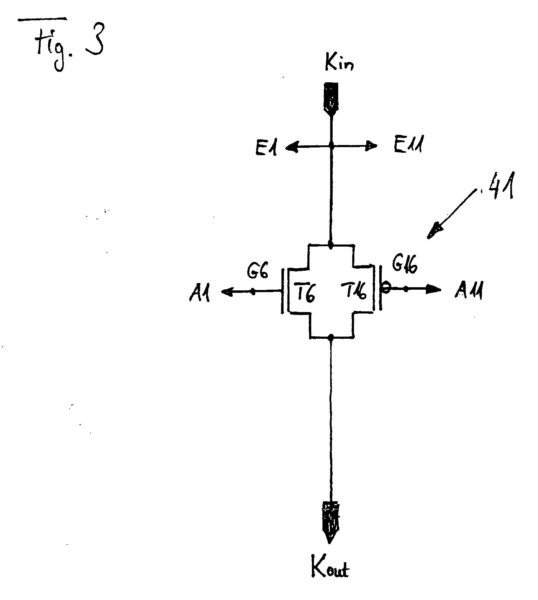

b) bei Betrieb des Transmission-Gates mit dem Gate-Boosting-Verfahren,
a) bei Betrieb des Transmission-Gates ohne jegliche Gatespannungsregelung,
c) bei Betrieb des Transmission-Gates mit einer Re gelschaltung entsprechend der Fig. 3

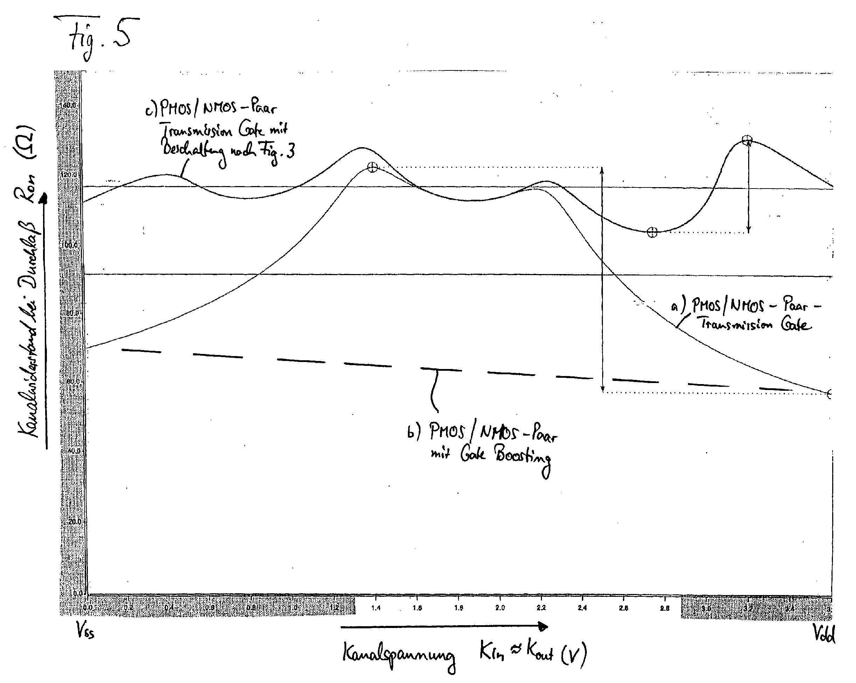

Fig. 6 ein Schaltbild eines dritten Ausführungsbeispiels einer erfindungsgemäßen Regelschaltung für die Gate-Spannung eines Schalttransistors im Form eines n-Kanal-MOSFET vom Anreicherungstyp

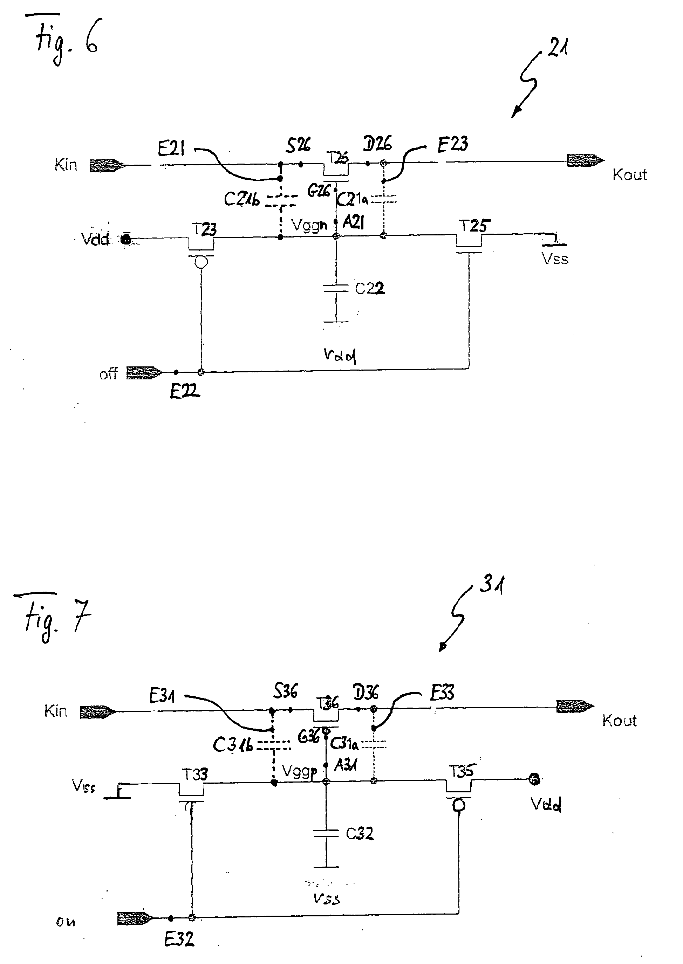

Fig. 7 ein Schaltbild eines vierten Ausführungsbeispiels einer erfindungsgemäßen Regelschaltung für die Gate-Spannung eines Schalttransistors in Form eines p-Kanal-MOSFET vom Anreicherungstyp

Fig. 8 ein Schaltbild einer Schalttransistoranordnung in Form eines Transmission-Gates mit einem p-Kanal-MOSFET / n-Kanal-MOSFET-Paar und deren Beschaltung mit den Regelschaltungen nach den Figuren 6 und 7

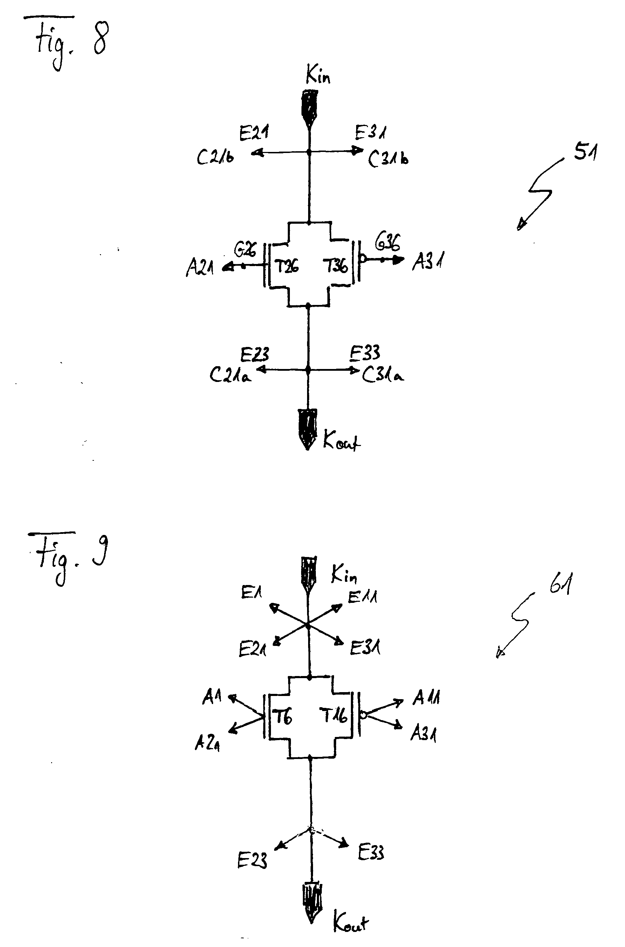

Fig. 9 ein Schaltbild einer Schalttransistoranordnung in Form eines Transmission-Gates mit einem p-Kanal-MOSFET / n-Kanal-MOSFET-Paar und deren Beschaltung mit den Regelschaltungen nach den Figuren 1, 2, 6 und 7

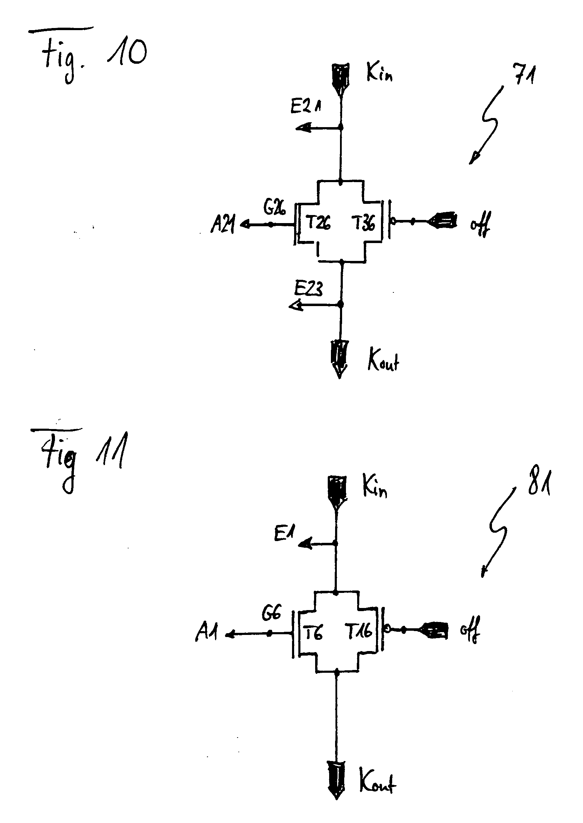

Fig. 10 ein Schaltbild einer Schalttransistoranordnung in Form eines Transmission-Gate mit einem p-Kanal-MOSFET / n-Kanal-MOSFET-Paar und deren Beschaltung mit der Regelschaltung nach der Figur 6

Fig. 11 ein Schaltbild einer Schalttransistoranordnung in Form eines Transmission-Gate mit einem p-Kanal-MOSFET

/ n-Kanal-MOSFET-Paar und deren Beschaltung mit der Regelschaltung nach der Figur 1

Gleiche oder funktionsgleiche Bauelementes sind in den jeweiligen Schaltbildern mit identischen Bezugszeichen versehen.

Die Fig. 1 zeigt ein Schaltbild eines ersten Ausführungsbeispiels einer erfindungsgemäßen Regelschaltung 1, mit welcher die Gate-Spannung Vggn eines n-Kanal-MOS-Feldeffektschalttransistors T6 vom Anreicherungstyp geregelt wird.

Die Regelschaltung 1 weist zwei Eingänge E1, E2 sowie einen Ausgang A1 auf. Dem Eingang E1 ist als Regelgröße die Kanalspannung, vorliegend die Kanaleingangsspannung Kin, als Regelgröße zuführbar. Dem Eingang E2 ist ein Schaltsignal zuführbar, um den Feldeffektschalttransistor T6 in den leitenden Zustand oder den sperrenden Zustand zu verbringen. Am Ausgang A1 ist das Ansteuersignal, nachfolgend als Gate-Spannung Vggn bezeichnet, für den Feldeffektschalttransistor T6 abgreifbar. (Es wird nachfolgend davon ausgegangen, daß diese Gate-Spannung Vggn genauso wie sämtliche Spannungen auf ein_gemeinsames Bezugspotential Vss bezogen sind).

Die Regelschaltung 1 umfasst im vorliegenden Ausführungsbeispiel fünf Transistoren, nämlich einen Source-Folger-Transistor T1, einen Stromquellen-Transistor T2, einen Spannungsteiler- und Umschalttransistor T3, einen Spannungsteilertransistor T4 sowie einen Umschalttransistor T5. Source-Folger-Transistor T1, Stromquellen-Transistor T2 und Spannungsteiler- und Umschalttransistor T3 sind als p-Kanal-MOS-Feldeffekttransistoren vom Anreicherungstyp ausgeführt. Der Spannungsteilertransistor T4 und der Umschalttransistor T5 sind ebenso wie der Feldeffektschalttransistor T6 als n-Kanal-MOS-Feldeffekttransistoren vom Anreicherungstyp ausgeführt.

Die einzelnen Bestandteile der Regelschaltung 1 sind in nachfolgend beschriebener Weise miteinander verbunden:

Die Drainanschlüsse des Source-Folger-Transistors T1 und des Umschalttransistors T5 sind mit dem Bezugspotential Vss verbunden. Der Sourceanschluss des Source-Folger-Transistors T1 ist mit dem Source-Anschluss des Umschalttransistors T5, dem Drain-Anschluss des Spannungsteilertransistors T4 und dem Drainanschluss des Stromquellen-Transistors T2 verbunden. Der Drain-Anschluss des Spannungsteiler- und Umschalttransistors T3 ist mit dem Source-Anschluss des Spannungsteilertransistors T4 verbunden. Diese Verbindung bildet gleichzeitig eine Verbindung zum Ausgang A1 der Regelschaltung 1. Weiterhin sind die Sourceanschlüsse des Stromquellen-Transistors T2 und des Spannungsteiler- und Umschalttransistors T3 mit einem Betriebspotential Vdd verbunden. Die Gates des Stromquellen-Transistors T2, des Spannungsteiler- und Umschalttransistors T3 sowie des Umschalttransistors T5 sind mit dem Eingang E2 der Regelschaltung 1 verbunden. Das Gate des Spannungsteilertransistors T4 ist mit dem Betriebspotential Vdd verbunden. Schließlich ist das Gate des Source-Folger-Transistors T1 mit dem Eingang E1 der Regelschaltung 1 verbunden.

Die Regelschaltung 1 setzt sich nunmehr im wesentlichen aus drei Funktionsblöcken zusammen:

Einer Schaltungsanordnung, um den Feldeffektschalttransistor T6 in den leitenden bzw. nichtleitenden Zustand zu versetzen umfassend die Transistoren T2, T3 und T5, einem eingangsseitigen Source-Folger gebildet durch den Transistor T1 und einem resistiven Transistorteiler, gebildet durch die Transistoren T3 und T4.

Geht man nunmehr davon aus, daß am Eingang E2 ein Niedrigpegel, vorzugsweise Bezugspotential angelegt wird, so wird der Schalttransistor T6 in den Durchlassbetrieb geschaltet. Führt man dem Schalttransistor T6 eingangsseitig Kin über seine Source S6 ein Nutzsignal zu, so wird dieses Nutzsignal über dessen Kanal K zum Drain D6, also zum Kanalausgang Kout durchgeleitet. Führt man gleichzeitig dem Eingang E1 der Regelschaltung 1 die Kanaleingangsspannung Kin zu, so wird diese Kanaleingangsspannung Kin über den Source-Folger T1 in die Source-Folger-Ausgangsspannung SFoutn transformiert. Diese Source-Folger-Ausgangsspannung SFoutn moduliert das Teilungsverhältnis des resistiven Teilers, welcher im vorliegenden Ausführungsbeispiel aus den Transistoren T3 und T4 besteht. Die resultierende geteilte Spannung Vggn wird über den Ausgang A1 der Regelschaltung 1 auf das Gate G6 des Feldeffektschalttransistors T6 geführt.

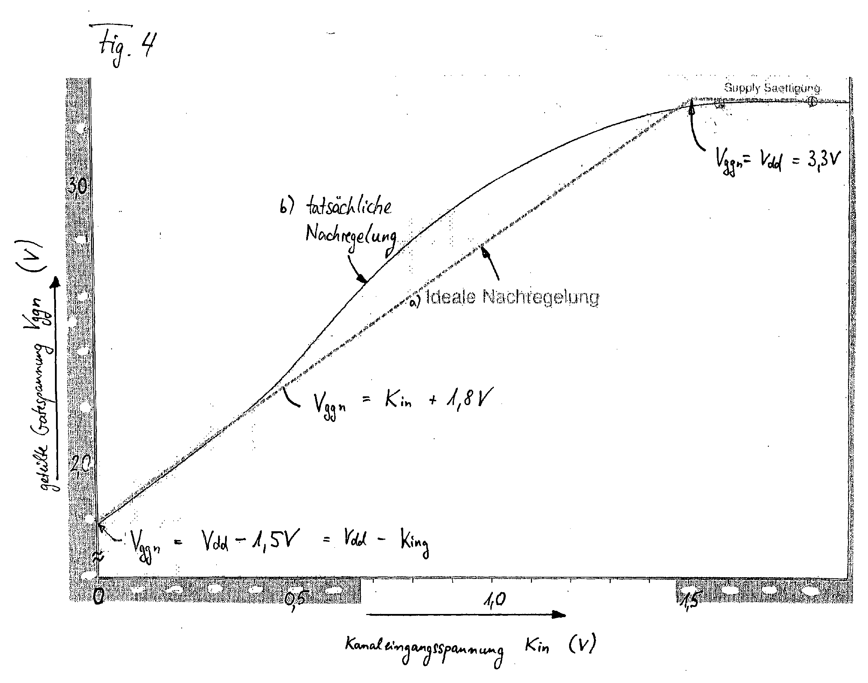

Im folgenden wird nunmehr die Wirkungsweise der Nachregelung des n-Kanal-Feldeffektschalttransistors T6 für ein begrenztes, jedoch durch die Dimensionierung des Spannungsteilers T3, T4 vorgegebenes Kanalspannungsintervall King unter Zuhilfenahme der Zeichnungsfigur 4 beschrieben. Die Fig. 4 zeigt zu diesem Zweck eine Simulation des Regelverhaltens der Regelschaltung 1 gemäß der Fig. 1, wobei in dem Diagramm die Gatespannung Vggn über der Kanalspannung Kin aufgetragen ist.

Das Kanalspannungsintervall King liegt im vorliegenden Ausführungsbeispiel in der unteren Hälfte des Versorgungsspannungsbereichs, nämlich zwischen 0 V und 1,5 V. Bei fehlender Kanalspannung Kin liegt am Gate G6 des Feldeffektschalttransistors T6 die Spannung vorzugsweise bei

$$Vggn = Vdd-King = 1,8\ V.$$

Das kann z.B. durch geeignete Dimensionierung von T3, T4 erreicht werden.

Mit steigender Kanalspannung Kin folgt die Spannung SFoutn am Ausgang des Sourcefolgertransistors T1 der Kanalspannung Kin um die Schwellspannung Vth (T1) des Transistors T1 versetzt:

$$SFoutn = Kin + Vth\ (T1).$$

Idealerweise sollte die Spannungsdifferenz zwischen dem Gate G6 des Transistors T6 und dem Kanal K, Kin, Kout konstant gehalten werden, d. h. eine Änderung der Kanaleingangsspannung Kin bzw. der Sourcefolgerausgangsspannung SFoutn sollte eine gleiche Änderung der Gatespannung Vggn des Feldeffektschalttransistors T6 nach sich ziehen. Dieser Zustand ist in der Fig. 4 durch die mit dem Bezugszeichen a) gekennzeichnete Kennlinie dargestellt.

Bestünde der Teiler T3, T4 aus konstanten ohmschen Widerständen, würde eine Änderung der Kanaleingangsspannung Kin bzw. der davon abgeleiteten Sourcefolgerausgangsspannung SFoutn um das fixe Teilungsverhältnis vermindert weitergegeben. Über einen Transistorteiler T3, T4, wie er vorliegend zum Einsatz kommt, lässt sich dagegen ein adaptives Teilungsverhältnis realisieren, wodurch innerhalb des vorbestimmten Kanalspannungsintervalls King die Gatespannung Vggn der Kanalspannung Kin mit einem näherungsweise konstanten Vorsatz folgt. Der tatsächliche Verlauf der geteilten Gleitspannung Vggn in Abhän-, gigkeit von der Kanaleingangsspannung Kin ist in der Zeichnungsfigur 4 durch die mit dem Bezugzeichen b) gekennzeichnete Kurve wiedergegeben.

Die passende Adaption des Teilerverhältnisses kommt dadurch zustande, daß die Leitfähigkeit der Transistoren T3, T4 über die Änderung der jeweiligen Kanalspannungen moduliert wird. So nimmt z. B. die Leitfähigkeit des Transistors T4 mit steigender Spannung SFoutn ab, während die Leitfähigkeit der Transistors T3 entsprechend zunimmt. Die Nachführung der geteilten Gatespannung Vggn läuft in die Sättigung bei der Versorgungsspannung Vdd, wenn sich die Differenzspannung zwischen Gate und Kanal des Transistors T4 dessen Schwellspannung Vth (T4) annähert:

$$Vdd - SFoutn > Vth\ (T4).$$

Eine Sättigung tritt im vorliegenden Ausführungsbeispiel also bei der Spannung

$$Vggn = Vdd = 3,3\ V$$

ein.

In diesem Zusammenhang wird ausdrücklich darauf hingewiesen, daß bei dem Gate-Boosting-Verfahren gemäß dem Stand der Technik eine derartige Sättigung nicht auftritt. Die Nachregelung beim Gate-Boosting-Verfahren folgt weiterhin dem linearen Anstieg entsprechend der idealen Nachregelung der mit dem Bezugszeichen a) gekennzeichneten Kurve.

Das Abschalten des Feldeffektschalttransistors T6 erfolgt durch das Steuersignal off über die Transistoren T5 und T3.

Vor der Inverterstruktur T5, T3 wird die Schaltspannung Vggn des Feldeffektschalttransistors T6 niederohmig auf Bezugspotential Vss gezogen. Die Stromquelle. T2 sowie der Sourcefolger T1 werden deaktiviert.

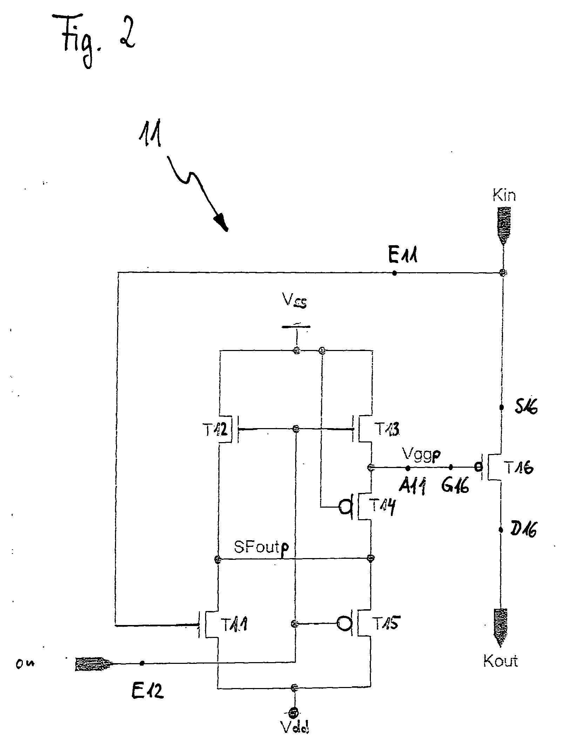

Es versteht sich für ein Fachmann von selbst, daß eine entsprechende Regelschaltung auch für die Gate-Spannung Vggp eines p-Kanal-MOS-Feldeffektschalttransistors vom Anreicherungtyp realisiert werden kann, indem die gesamte Regelschaltung in komplementärer Weise ausgeführt wird. Eine derartige Regelschaltung 11 für die Gate-Spannung Vggp eines p-Kanal-MOS-Feldeffektschalttransistors vom Anreicherungstyp ist als Schaltbild der Fig. 2 zu entnehmen.

Auch die Regelschaltung 11 umfasst zwei Eingänge E11, E12 sowie einen Ausgang A11. Dem Eingang E11 ist als Regelgröße die Kanalspannung, vorliegend die Kanaleingangsspannung Kin als Regelgröße zuführbar. Dem Eingang E12 ist ein Schaltsignal zuführbar, um den Feldeffektschalttransistor T16 in den leitenden Zustand oder den sperrenden Zustand zu verbringen. Am Ausgang A11 ist die Gate-Spannung Vggp für den Feldeffektschalttransistor T16 abgreifbar. Es wird wiederum davon ausgegangen, dass sämtliche Spannungen auf ein gemeinsames Bezugspotential Vss bezogen sind.

Auch diese Regelschaltung 11 umfaßt demzufolge fünf Transistoren T11, T12, T13, T14, T15. Die Transistoren T11 - T13 sind n-Kanal-MOS-Feldeffekttransistoren vom Anreicherungstyp, die beiden Transistoren T14, T15 liegen in Form von p-Kanal-MOS-Feldeffekttransistoren vom Anreicherungstyp vor.

Die Regelschaltung 11 umfasst im vorliegenden Ausführungsbeispiel einen Source-Folger-Transistor T11, einen Stromquellen-Transistor T12, einen Spannungsteiler- und Umschalttransistor T13, einen Spannungsteilertransistor T14 sowie einen Umschalttransistor T15. Source-Folger-Transistor T11, Stromquellen-Transistor T12 und Spannungsteiler- und Umschalttransistor T13 sind als n-Kanal-MOS-Feldeffekttransistoren vom Anreicherungstyp ausgeführt. Der Spannungsteilertransistor T14 und der Umschalttransistor T15 sind ebenso wie der Feldeffektschalttransistor T16 als p-Kanal-MOS-Feldeffekttransistoren vom Anreicherungstyp ausgeführt.

Die einzelnen Bestandteile der Regelschaltung 11 sind in analoger Weise zur Schaltungsanordnung nach der Fig. 1 in der nachfolgend beschriebenen Weise miteinander verbunden:

Die Drainanschlüsse des Source-Folger-Transistors T11 und des Umschalttransistors T15 sind mit Betriebspotential verbunden. Der Sourceanschluss des Source-Forlger-Transistors T11 ist mit dem Source-Anschluss des Umschalttransistors T15, dem Drain-Anschluss des Spannungsteilertransistors T14 und dem Drain-anschluss des Stromquellen-Transistors T12 verbunden. Der Drain-Anschluss des Spannungsteiler- und Umschalttransistors T13 ist mit dem Source-Anschluss des Spannungsteilertransistors T14 verbunden. Diese Verbindung bildet gleichzeitig eine Verbindung zum Ausgang A11 der Regelschaltung 11. Weiterhin sind die Sourceanschlüsse des Stromquellen-Transistors T12 und des Spannungsteiler- und Umschalttransistors T13 mit einem Bezugspotential Vss verbunden. Die Gates des Stromquellen-Transistors T12, des Spannungsteiler- und Umschalttransistors T13 sowie des Umschalttransistors T15 sind mit dem Eingang E12 der Regelschaltung 11 verbunden. Das Gate des Spannungsteilertransistors T14 ist mit dem Bezugspotential Vss verbunden. Schließlich ist das Gate des Source-Folger-Transistors T11 mit dem Eingang E11 der Regelschaltung 11 verbunden.

Die Wirkungsweise der komplementären Regelschaltung 11 zur Ansteuerung des p-Kanal-MOS-Feldeffektschalttransistors T16 für eine Nachführung der Gatespannung in der oberen Hälfte des Versorgungsspannungsbereichs erfolgt analog zur obigen Beschreibung.

Da es mittlerweile üblich geworden ist, aus Symmetriegründen Transistorschaltungen in CMOS-Technologie auszuführen, zeigt die Fig. 3 ein Schaltbild einer Schalttransistoranordnung in Form eines Transmission-Gates 41 mit einem p-Kanal-MOSFET / n-Kanal-MOSFET-Paar und deren Beschaltung mit den Regelschaltungen nach den Fig. 1 und 2. Das MOSFET-Paar umfasst im vorliegenden Ausführungsbeispiel die beiden Feldeffektschalttransistoren T6 und T16 bei denen einerseits die Source-Anschlüsse und andererseits die Drainanschlüsse miteinander verbunden sind. Verbindet man nunmehr entsprechend der Weisung gemäß der Fig. 3 den Kanaleingang Kin des Transmission-Gates 41 mit dem Eingang E1 der Regelschaltung 1 gemäß der Fig. 1 sowie das Gate G6 des Schalttransistors T6 mit dem Ausgang A1 der Regelschaltung 1 und in entsprechender Weise den Eingang Kin des Kanals K mit dem Eingang E11 der Regelschaltung 11 sowie das Gate G16 des Schalttransistors T16 mit dem Ausgang A11 der Regelschaltung 11 gemäß der Figur 2, so erhält man eine Gesamtregelschaltung für das Transmission-Gate 41 mit dessen Hilfe der Kanalwiderstand Ron im Durchlassbetrieb des Transmission-Gates 41 über dem gesamten Eingangsspannungsintervall nur vergleichsweise geringfügig variiert. Eine Simulation des Kanalwiderstands Ron im Durchlassbetrieb ist in der Zeichnungsfigur 5 repräsentiert durch den Kurvenverlauf c) über einen Betriebsspannungsbereich King von 0 bis Vdd = 3,6 Volt dargestellt. Die entsprechenden Kanalwiderstände Ron eines PMOS/NMOS-Paar-Transmission-Gates ohne erfindungsgemäße Nachregelschaltung sowie eines PMOS/NMOS-Paars mit Gate-Boosting sind in der Zeichnungsfigur 5 über der Kanalspannung Kin durch die mit den Bezugszeichen a) bzw. b) gekennzeichneten Kurven gegenübergestellt.

Durch ein Nachführen der Gate-Spannung Vggn, Vggp mit der Kanalspannung Kin, Kout wird die Variation des Kanalwiderstandes Ron und damit die auftretenden Verzerrungen wesentlich reduziert. Betrachtet man den NMOS-Transistor T6 bzw. den PMOS-Transistor T16 im Transmission-Gate 41 vereinfacht als RC-Glied mit dem als konstant angenommenen Kanalwiderstand R und der ebenfalls als konstant angenommenen (parasitären) Ausgangskapazität C, so wird ein Sinussignal am Kanaleingang Kin lediglich gedämpft. Variiert dagegen der Kanalwiderstand R in Abhängigkeit von der Kanalspannung, kommt es zu einer Verzerrung des Sinus-Signals gemäß folgender Näherung:

$$\text{Pdistortion} \, / \, \text{Psignal} = 25 * dR * Rav * C^2 * f^2$$

mit der Störleistung Pdistortion, der geschalteten Signalleistung Psignal, der Änderung dR des Kanalwiderstandes des Transmission-Gates 41 innerhalb eines bestimmten Kanalspannungsbereiches, dem durchschnittlichen Kanalwiderstand Rav und der Signalfrequenz f.

Je nach applikativ erforderlichem Kanalspannungsintervall am Transmission-Gate kann auf eine komplementäre Ausführung der Nachregelung verzichtet werden: So kann beispielsweise bei einem Signalspannungssignal in der oberen Hälfte des Versorgungsspannungsbereichs auf eine Nachregelung des NMOS-Transistors verzichtet werden. Entsprechendes gilt bei einem Signalspannungsbereich in der unteren Hälfte des Versorgungsspannungsbereichs für den PMOS-Transistor. Letztere Ausführungsvariante einer Schalttransistoranordnung in Form eines Transmission-Gates 81 und deren Beschaltung ist in der Figur 11 beispielhaft dargestellt.

Eine weitere Realisierungsmöglichkeit kann in einer Modifikation der Regelschaltungen gemäß den Figuren 1 und 2 dahingehend bestehen, dass die Nachregelung über den Source-Folger T1, T11 und resistiven Teiler T3, T4; T13, T14 gänzlich entfällt und der Transistor T4, T14 durch einen Kurzschluss ersetzt wird. Der Ausgang A1, A11I wird bei dieser Modifikation DC-mäßig hochohmig über den verbleibenden Umschalttransistor T3, T13 von der Betriebsspannung Vdd getrieben und AC-mäßig über einen kapazitiven Teiler.

Konkret ist die entsprechende Regelschaltung 21 für die Gate-Spannung Vggn eines n-Kanal-MOS-Feldeffektschalttransistors vom Anreicherungstyp in der Figur 6, die korrespondierende Regelschaltung 31 für die Gate-Spannung Vggp eines p-Kanal-MOS-Feldeffekt-Schalttransistors T36 vom Anreicherungstyp in der Figur 7 dargestellt.

Nachfolgend wird nunmehr zunächst die Regelschaltung 21 gemäß der Figur 6 im Einzelnen beschrieben:

Der anzusteuernde Schalter besteht im vorliegenden Ausführungsbeispiel wiederum aus einem n-Kanal-MOS-Feldeffekt-Schalttransistor T26 vom Anreicherungstyp. Dessen Source-Anschluss S26 kann ein Nutzsignal Kin zugeführt werden, welches je nach Beschaltung des Gates G26 des Schalttransistors T26 zu dessen Drain T26 durchgeleitet wird oder nicht.

Die Regelschaltung 21 umfasst im vorliegenden Ausführungsbeispiel drei Eingänge E21, E23, E22 sowie einen Ausgang A21. Den Eingängen E21, E23 sind Kanalspannungssignale Kin, Kout zuführbar, dem Eingang E22 ist ein Schaltsignal off zuführbar, mit dessen Hilfe der Schalttransistor 26 in den leitenden oder sperrenden Zustand versetzbar ist. Dem Ausgang A21 der Regelschaltung 21 entnimmt man das Ansteuersignal für das Gate G26 des Feldeffekt-Schalttransistors T26.

Die Regelschaltung umfasst als Bauteile zwei Transistoren T23, T25 sowie drei Kondensatoren C21a, C21b, C22. Wahlweise kann auf einen der beiden Kondensatoren C21a, C21b verzichtet werden. Die Kondensatoren C21a, C21b können auch durch die parasitäre Gate-Kanal-Kapazität der Schalttransistoren T26 gebildet werden.

Der Eingang E21 ist auf eine Klemme des Kondensators C21b geführt. Die andere Klemme des Kondensators C21b ist einerseits auf den Drain-Anschluss des Transistors T23, den Source-Anschluss des als n-Kanal-MOS-Feldeffekt-Transistor ausgebildeten Transistors T25, eine Klemme des Kondensators C22, eine Klemme des Kondensators C21a sowie den Ausgang A21 der Regelschaltung 21 geführt. Die andere Klemme des Kondensators C21a ist mit dem Eingang E23, die andere Klemme des Kondensators C22 mit einem Bezugspotential Vss verbunden. Der Source-Anschluss des p-Kanal-MOS-Feldeffekt-Transistors T23 ist mit einem Betriebspotential Vdd verbunden. Der Drain-Anschluss des Transistors T25 ist mit einem (gegenüber dem Betriebspotential Vdd niedrigeren) Bezugspotential Vss verbunden. Die beiden Gates der Transistoren T23, T25 sind mit dem Eingang E22 der Regelschaltung 21 verbunden.

Der Feldeffekt-Schalttransistor T26 wird durch eine positive Spannung (z. B. Vold) am Eingang E22 gesperrt. Liegt der Eingang E22 auf Bezugspotential Vss, so wird das Gate G26 des Feldeffekt-Schalttransistors T26 hochohmig über den Transistor T23 von der Betriebsspannung Vdd getrieben. Eine sich zeitlich ändernde Kanalspannung Kin, Kout wird über den kapazitiven Teiler bestehend aus den beiden Kondensatoren C21a und C21b einerseits und der Kapazität C22 andererseits am Ausgang A21 als geteilte Gate-Spannung Vggn entsprechend der nachfolgend angegebenen Gleichung ausgegeben:

$$Vggn = Vdd + Vac * \sin(ft) *(C21a + C21b) / (C21a + C21b + C22),$$

wobei z.B. $Kin \cong Vdc + Vac * \sin(ft)$ und $Kin \approx Kout$ angenommen ist. So wird z. B. für (C21a + C21b) = C22 eine Spannungsänderung im Kanal Kin, Kout zur Hälfte am Gate G26 des Schalttransistors T26 nachgeregelt. Die Spannungsschwankung zwischen Kanal K und Gate G26 ist damit halbiert. Im ungünstigsten Fall entsteht eine durch das Kapazitätsverhältnis begrenzte Überspannung von Vdd * (1 + (C21a + C21b) / (C21a + C21b + C22)).

Der Vollständigkeit halber zeigt die Figur 7 ein Schaltbild eines vierten Ausführungsbeispiels einer erfindungsgemäßen Regelschaltung 31 für die Gate-Spannung Vggp eines Schalttransistors in Form eines p-Kanal-MOSFET T36 vom Anreichungstyp, welche komplementär zur Schaltungsanordnung gemäß der Figur 6 ausführt ist.

Der anzusteuernde Schalter besteht im vorliegenden Ausführungsbeispiel also aus dem p-Kanal-MOS-Feldeffekt-Schalttransistor T36 vom Anreicherungstyp. Dessen Source-Anschluss S36 kann ein Nutzsignal Kin zugeführt werden, welches je nach Beschaltung des Gates G36 des Schalttransistors T36 zu dessen Drain T36 durchgeleitet wird oder nicht.

Die Regelschaltung 31 umfasst im vorliegenden Ausführungsbeispiel drei Eingänge E31, E33, E32 sowie einen Ausgang A31. Den Eingängen E31, E33 sind Kanalspannungssignale Kin, Kout zuführbar, dem Eingang E32 ist ein Schaltsignal on off zuführbar, mit dessen Hilfe der Schalttransistor 36 in den leitenden oder sperrenden Zustand versetzbar ist. Dem Ausgang A31 der Regelschaltung 31 entnimmt man das Ansteuersignal für das Gate G36 des Feldeffekt-Schalttransistors T36. Die Regelschaltung umfasst als (z. B. diskrete) Bauteile zwei Transistoren T33, T35 sowie drei Kondensatoren C31a, C31b, C32.

Der Eingang E31 ist auf eine Klemme des Kondensators C31b geführt. Die andere Klemme des Kondensators C31b ist einerseits auf den Drain-Anschluss des Transistors T33, den Source-Anschluss des als p-Kanal-MOS-Feldeffekt-Transistor ausgebildeten Transistors T35, eine Klemme des Kondensators C32, eine Klemme des Kondensators C31a sowie den Ausgang A31 der Regelschaltung 31 geführt. Die andere Klemme des Kondensators C31a ist mit dem Eingang E33, die andere Klemme des Kondensators C32 mit einem Betriebspotential, vorzugsweise Vdd, verbunden. Der Source-Anschluss des n-Kanal-MOS-Feldeffekt-Transistors T33 ist mit einem Bezugspotential Vss verbunden. Der Drain-Anschluss des Transistors T35 ist mit dem (gegenüber dem Bezugspotential Vss höheren) Betriebspotential Vdd verbunden. Die beiden Gates der Transistoren T33, T35 sind mit dem Eingang E32 der Regelschaltung 31 verbunden.

Funktional ist die Regelschaltung 31 nach der Fig. 7 komplementär zur Regelschaltung 21 nach der Fig. 6 ausgeführt.

Die Figuren 8 bis 10 zeigen Schaltbilder von Schalttransistor-Anordnungen in Form von Transmission-Gates 51, 61, 71 mit einem p-Kanal-MOSFET / n-Kanal-MOSFET-Paar und deren Beschaltung mit unterschiedlichen Regelschaltungen nach den Figuren 1, 2, 6 und 7.

So ist z. B. das Transmission-Gate 51 mit zwei Regelschaltungen 21, 31 beschaltet, wie sie in den Figuren 6 und 7 dargestellt sind. Diese Ausführungsvariante eignet sich insbesondere zum Schalten sehr hochfrequenter Nutzsignale (20MHz - 50MHz), während eine Schaltungsanordnung wie sie in der Fig. 3 dargestellt ist für Frequenzen bis etwa 20 MHz geeignet ist.

Sollen Nutzsignale mit stark variierenden Frequenzen von ca. 0 Hz bis 50 MHz durch das Transmission-Gate durchgeleitet werden, so bietet sich eine Schaltungsanordnung entsprechend der Fig. 9 an, bei welcher sowohl eine NMOS/PMOS Nachregelung als auch eine kapazitive Nachregelung erfolgt.

Je nachdem, ob bevorzugt Hochvolt- oder Niedervolt-Nutzsignale über ein Transmission-Gate übertragen werden sollen, kann auch auf entsprechende Regelschaltungen verzichtet werden. Die Fig. 10 und 11 zeigen Schaltungsanordnungen, welche sich zur verzerrungsarmen Durchleitung von Niederspannungssignalen, weniger jedoch zur Durchleitung von Hochspannungssignalen eignen.

Die erfindungsgemäßen Regelschaltungen eignen sich zur Ansteuerung (niederfrequent geschalteter) statischer Schalter in hochfrequenten Signalpfaden, z. B. für analoge Videosignale mit geringen Verzerrungen. Bei Verwendung einer kapazitiven Teilerstruktur können die Schaltungsanordnungen auch in hochfrequent geschalteten Signalpfaden eingesetzt werden.

Bezugszeichenliste

| | |
|---|---|
| 1 | Regelschaltung für die Gate-Spannung eines n-Kanal-MOS-Feldeffektschalttransistors vom Anreicherungstyp |
| 11 | Regelschaltung für die Gate-Spannung eines p-Kanal-MOS-Feldeffektschalttransistors vom Anreicherungstyp |
| 21 | Regelschaltung für die Gate-Spannung eines n-Kanal-MOS-Feldeffektschalttransistors vom Anreicherungstyp |
| 31 | Regelschaltung für die Gate-Spannung eines p-Kanal-MOS-Feldeffektschalttransistors vom Anreicherungstyp |
| 41 | Transmission-Gate mit einem n-Kanal-MOS-Feldeffektschalttransistors vom Anreicherungstyp und einem p-Kanal-MOS-Feldeffektschalttransistors vom Anreicherungstyp und dessen Ansteuerung mit Hilfe der Regelschaltungen 1 und 11 |
| 51 | Transmission-Gate mit einem n-Kanal-MOS-Feldeffektschalttransistors vom Anreicherungstyp und einem p-Kanal-MOS-Feldeffektschalttransistors vom Anreicherungstyp und dessen Ansteuerung mit Hilfe der Regelschaltungen 21 und 31 |
| 61 | Transmission-Gate mit einem n-Kanal-MOS-Feldeffektschalttransistors vom Anreicherungstyp und einem p-Kanal-MOS-Feldeffektschalttransistors vom Anreicherungstyp und dessen Ansteuerung mit Hilfe der Regelschaltungen 1, 11, 21 und 31 |
| 71 | Transmission-Gate mit einem n-Kanal-MOS-Feldeffektschalttransistors vom Anreicherungstyp und einem p-Kanal-MOS-Feldeffektschalttransistors vom Anreicherungstyp und dessen Ansteuerung mit Hilfe der Regelschaltung 21 |
| 81 | Transmission-Gate mit einem n-Kanal-MOS-Feldeffektschalttransistors vom Anreicherungstyp und einem p-Kanal-MOS-Feldeffektschalttransistors vom Anreicherungstyp und dessen Ansteuerung mit Hilfe der Regelschaltung 1 |
| | |
| T1 | Source-Folger-Transistor (p-Kanal-MOS-Feldeffekttransistor vom Anreicherungstyp) |
| T2 | Stromquellen-Transistor (p-Kanal-MOS-Feldeffekttransistor vom Anreicherungstyp) |
| T3 | Spannungsteiler- und Umschalttransistor (p-Kanal-MOS-Feldeffekttransistor vom Anreicherungstyp) |
| T4 | Spannungsteilertransistor (n-Kanal-MOS-Feldeffekttransistor vom Anreicherungstyp) |
| T5 | Umschalttransistor (n-Kanal-MOS-Feldeffekttransistor vom Anreicherungstyp) |
| T6 | Schalttransistor (n-Kanal-MOS-Feldeffekttransistor vom Anreicherungstyp) |
| T11 | Source-Folger-Transistor (n-Kanal-MOS-Feldeffekttransistor vom Anreicherungstyp) |
| T12 | Stromquellen-Transistor (n-Kanal-MOS-Feldeffekttransistor vom Anreicherungstyp) |
| T13 | Spannungsteiler- und Umschalttransistor (n-Kanal-MOS-Feldeffekttransistor vom Anreicherungstyp) |
| T14 | Spannungsteilertransistor (p-Kanal-MOS-Feldeffekttransistor vom Anreicherungstyp) |
| T15 | Umschalttransistor (p-Kanal-MOS-Feldeffekttransistor vom Anreicherungstyp) |
| T16 | Schalttransistor (p-Kanal-MOS-Feldeffekttransistor vom Anreicherungstyp) |
| T23 | Umschalttransistor (p-Kanal-MOS-Feldeffekttransistor vom Anreicherungstyp) |
| T25 | Umschalttransistor (n-Kanal-MOS-Feldeffekttransistor vom Anreicherungstyp) |
| T26 | Schalttransistor (n-Kanal-MOS-Feldeffekttransistor vom Anreicherungstyp) |

| | |
|---|---|
| T33 | Umschalttransistor (n-Kanal-MOS-Feldeffekttransistor vom Anreicherungstyp) |
| T35 | Umschalttransistor (p-Kanal-MOS-Feldeffekttransistor vom Anreicherungstyp) |
| T36 | Schalttransistor (p-Kanal-MOS-Feldeffekttransistor vom Anreicherungstyp) |
| Vdd | Betriebspotential |
| Vss | Bezugspotential |
| K | Kanal |
| Kin | Kanaleingangsspannung |
| Kout | Kanalausgangsspannung |
| off | Ausschaltspannung / Steuerspannung |
| on | Einschaltspannung / Steuerspannung |
| SFoutn | Source-Folger-Ausgangsspannung |
| SFoutp | Source-Folger-Ausgangsspannung |
| Vggn | Gatespannung des Schalttransistors |
| Vggp | Gatespannung des Schalttransistors |
| Vth | Schwellspannung |
| King | Grenzspannung der Regelung / Kanalspannungsintervall der Regelung |
| Ron | Durchlass-Kanalwiderstand |
| E1 | Eingang |
| E2 | Eingang |
| A1 | Ausgang |

| | |
|---|---|
| E11 | Eingang |
| E12 | Eingang |
| A11 | Ausgang |
| E21 | Eingang |
| E22 | Eingang |
| E23 | Eingang |
| A21 | Ausgang |
| E31 | Eingang |
| E32 | Eingang |
| E33 | Eingang |
| A31 | Ausgang |
| C21a | Kapazität |
| C21b | Kapazität |
| C22 | Kapazität |
| C31a | Kapazität |
| C31b | Kapazität |
| C32 | Kapazität |
| S6 | Source |
| D6 | Drain |
| G6 | Gate |
| S16 | Source |
| D16 | Drain |
| G16 | Gate |
| S26 | Source |
| D26 | Drain |
| G26 | Gate |

| | |
|---|---|
| S36 | Source |
| D36 | Drain |
| G36 | Gate |

| | |
|---|---|
| Pdistortion | Störleitung |
| Psignal | Signalleistung |
| dR | Änderung des Kanalwiderstands |
| Rav | durchschnittlicher Kanalwiderstand |
| f | Signalfrequenz |

**Patentansprüche**

1.  Regelschaltung (1, 11, 21, 31) für einen eine Source (S6, S16, S26, S36), ein Drain (D6, D16, D26, D36), ein zugeordnetes Gate (G6, G16, G26, G36) und einen die Source (S6, S16, S26, S36) und das Drain (D6, D16, D26, D36) verbindenden Kanal (K) aufweisenden Feldeffektschalttransistor (T6, T16, T26, T36), mit welcher der Kanalwiderstand (Ron) des Feldeffektschalttransistors (T6, T16, T26, T36) in einem Durchlassbetrieb (on) auf einen im wesentlichen konstanten Widerstandswert regelbar ist,
    **dadurch gekennzeichnet, dass**
    eine erste Schaltungsanordnung (1, 11) vorgesehen ist, um die Gate-Source-Spannung des Feldeffektschalttransistors (T6, T16, T26, T36) in dem Durchlassbetrieb lediglich dann auf einen im wesentlichen konstanten Spannungswert zu regeln, wenn die Kanalspannung (Kin, Kout) innerhalb eines vorgegebenen Kanalspannungsintervalls (0 ≤ Kin, Kout ≤ 1,5 Volt) liegt und/oder dass eine zweite Schaltungsanordnung (21, 31) vorgesehen ist, um die Gate-Source-Spannung des Feldeffektschalttransistors (T6, T16, T26, T36) in dem Durchlassbetrieb auf einen Spannungswert (Vdd - Kin * C2/(C1+C2)) zu regeln, welcher lediglich um einen vorgegebenen Bruchteil (C2/(C1+C2)) der Kanalspannung (Kin, Kout) schwankt.

2.  Regelschaltung nach Anspruch 1,
    **dadurch gekennzeichnet, dass**
    die erste Schaltungsanordnung (1, 11) eine spannungsabhängige Spannungsteilerschaltung (T3, T4; T13, T14) umfasst, welcher eingangsseitig die Kanalspannung (Kin, Kout) oder eine von der Kanalspannung (Kin, Kout) abgeleitete Spannung (SFoutn, SFoutp) zuführbar ist.

3.  Regelschaltung nach Anspruch 2,
    **dadurch gekennzeichnet, dass**
    die erste Schaltungsanordnung (1, 11) eine Spannungsfolgerschaltung (T1, T11) umfasst, welcher eingangsseitig die Kanalspannung (Kin, Kout) zuführbar ist und an welcher ausgangsseitig die von der Kanalspannung (Kin, Kout) abgeleitete Spannung (SFoutn, SFoutp) abgreifbar ist.

4.  Regelschaltung nach Anspruch 3, insbesondere für einen Feldeffektschalttransistor in Form eines n-Kanal Feldeffekttransistors (T6) vom Anreicherungstyp,
    **dadurch gekennzeichnet, dass**

    - die Spannungsfolgerschaltung einen ersten p-Kanal Feldeffekttransistor (T1) vom Anreicherungstyp mit einem Gate, einer Source und einem Drain umfasst, dass
    - ein zweiter p-Kanal Feldeffekttransistor (T2) vom Anreicherungstyp mit einem Gate, einer Source und einem Drain vorgesehen ist, dass
    - die Spannungsteilerschaltung (T3) einen dritten p-Kanal Feldeffekttransistor vom Anreicherungstyp mit einem Gate, einer Source und einem Drain sowie einen ersten n-Kanal Feldeffekttransistor (T4) vom Anreicherungstyp mit einem Gate, einer Source und einem Drain umfasst und dass
    - ein zweiter n-Kanal Feldeffekttransistor (T5) vom Anreicherungstyp mit einem Gate, einer Source und einem Drain vorgesehen ist, wobei
    - das Gate des ersten p-Kanal Feldeffekttransistors (T1) mit dem Kanal (K), insbesondere der Source (S6) oder dem Drain (D6), des Feldeffektschalttransistors (T6) verbunden ist, dass
    - die Source des ersten p-Kanal Feldeffekttransistors (T1), das Drain des zweiten p-Kanal Feldeffekttransistors (T2), das Drain des ersten n-Kanal Feldeffekttransistors (T4) und die Source des zweiten n-Kanal Feldeffekttransistors (T5) miteinander verbunden sind, dass
    - das Drain des dritten p-Kanal Feldeffekttransistors (T3) und die Source des ersten n-Kanal Feldeffekttransistors (T4) mit dem Gate (G6) des Feldeffektschalttransistors (6) verbunden sind, dass
    - die Source des zweiten p-Kanal Feldeffekttransistors (T2), die Source des dritten p-Kanal Feldeffekttransistors (T3) und das Gate des ersten n-Kanal-Feldeffekttransistors (T4) mit einem Betriebspotential (Vdd) verbunden sind, dass
    - das Drain des ersten p-Kanal Feldeffekttransistors (T1) und das Drain des zweiten n-Kanal-Feldeffekttransistors (T2) mit einem Bezugspotential (Vss) verbunden sind und dass
    - das Gate des zweiten p-Kanal Feldeffekttransistors (T2), das Gate des dritten p-Kanal Feldeffekttransistors (T3) und das Gate des zweiten n-Kanal-Feldeffekttransistors (T5) mit einem Eingang (E2) verbunden sind, welchem eine Schaltspannung (off) zum Schalten des Feldeffektschalttransistors (T6) zuführbar ist.

5.  Regelschaltung nach Anspruch 3, insbesondere für einen Feldeffektschalttransistor in Form eines p-Kanal Feldeffekttransistors (T16) vom Anreicherungstyp,
**dadurch gekennzeichnet, dass**

- die Spannungsfolgerschaltung einen ersten n-Kanal Feldeffekttransistor (T11) vom Anreicherungstyp mit einem Gate, einer Source und einem Drain umfasst, dass
- ein zweiter n-Kanal Feldeffekttransistor (T12) vom Anreicherungstyp mit einem Gate, einer Source und einem Drain vorgesehen ist, dass
- die Spannungsteilerschaltung einen dritten n-Kanal Feldeffekttransistor (T13) vom Anreicherungstyp mit einem Gate, einer Source und einem Drain sowie einen ersten p-Kanal Feldeffekttransistor (T14) vom Anreicherungstyp mit einem Gate, einer Source und einem Drain umfasst und dass
- ein zweiter p-Kanal Feldeffekttransistor (T15) vom Anreicherungstyp mit einem Gate, einer Source und einem Drain vorgesehen ist, wobei
- das Gate des ersten n-Kanal Feldeffekttransistors (T11) mit dem Kanal (K), insbesondere der Source (S16) oder dem Drain (D16), des Feldeffektschalttransistors (T16) verbunden ist, dass
- die Source des ersten n-Kanal Feldeffekttransistors (T11), das Drain des zweiten n-Kanal Feldeffekttransistors (T12), das Drain des ersten p-Kanal Feldeffekttransistors (T14) und die Source des zweiten p-Kanal Feldeffekttransistors (T15) miteinander verbunden sind, dass
- das Drain des dritten n-Kanal Feldeffekttransistors (T13) und die Source des ersten p-Kanal Feldeffekttransistors (T14) mit dem Gate (G16) des Feldeffektschalttransistors (T16) verbunden sind, dass
- die Source des zweiten n-Kanal Feldeffekttransistors (T12), die Source des dritten n-Kanal Feldeffekttransistors (T13) und das Gate des ersten p-Kanal-Feldeffekttransistors (T14) mit einem Bezugspotential (Vss) verbunden sind, dass
- das Drain des ersten n-Kanal Feldeffekttransistors (T11) und das Drain des zweiten p-Kanal-Feldeffekttransistors (T15) mit einem Betriebspotential (Vdd) verbunden sind und dass
- das Gate des zweiten n-Kanal Feldeffekttransistors (T12), das Gate des dritten n-Kanal Feldeffekttransistors (T13) und das Gate des zweiten p-Kanal-Feldeffekttransistors (T15) mit einem Eingang (E12) verbunden sind, welchem eine Schaltspannung (off) zum Schalten des Feldeffektschalttransistors (T16) zuführbar ist.

6. Regelschaltung nach einem der vorangegangenen Ansprüche, insbesondere für einen Feldeffektschalttransistor in Form eines n-Kanal Feldeffekttransistors (T26) vom Anreicherungstyp,
**dadurch gekennzeichnet, dass**

- die zweite Schaltungsanordnung (21) einen p-Kanal Feldeffekttransistor (T23) vom Anreicherungstyp mit einem Gate, einer Source und einem Drain, einen n-Kanal Feldeffekttransistor (T25) vom Anreicherungstyp mit einem Gate, einer Source und einem Drain, einen ersten Kondensator (C21b) und/oder einen zweiten Kondensator (C21a) sowie einen weiteren Kondensator (C22) umfasst, dass
- der Kanal (K) des Feldeffektschalttransistors (T26) über den mit der Source (S26) des Feldeffektschalttransistors (T26) verbundenen ersten Kondensator (C21b) mit dem Drain des p-Kanal Feldeffekttransistors (T23), der Source des n-Kanal Feldeffekttransistors (T25) und mit dem Gate (G26) des Feldeffektschalttransistors (T26) verbunden ist und/oder dass der Kanal (K) des Feldeffektschalttransistors (T26) über den mit dem Drain (D26) des Feldeffektschalttransistors (T26) verbundenen zweiten Kondensator (C21a) mit dem Drain des p-Kanal Feldeffekttransistors (T23), der Source des n-Kanal Feldeffekttransistors (T25) und mit dem Gate (G26) des Feldeffektschalttransistors (T26) verbunden ist, dass
- das Drain des p-Kanal Feldeffekttransistors (T23), die Source des n-Kanal Feldeffekttransistors (T25) und das Gate (G26) des Feldeffektschalttransistors (T26) über den weiteren Kondensator (C22) mit einem Bezugspotential (Vss) verbunden ist, dass
- die Source des p-Kanal Feldeffekttransistors (T23) mit einem Betriebspotential (Vdd) verbunden ist, dass
- das Drain des n-Kanal Feldeffekttransistors (T25) mit dem Bezugspotential (Vss) verbunden ist und dass
- das Gate des p-Kanal Feldeffekttransistors (T23) und das Gate des n-Kanal Feldeffekttransistors (T25) mit einem Eingang (E22) verbunden sind, welchem eine Schaltspannung (off) zum Schalten des Feldeffektschalttransistors (T26) zuführbar ist.

7. Regelschaltung nach einem der Ansprüche 1 bis 5, insbesondere für einen Feldeffektschalttransistor in Form eines p-Kanal Feldeffekttransistors (T36) vom Anreicherungstyp,
**dadurch gekennzeichnet, dass**

- die zweite Schaltungsanordnung (31) einen n-Kanal Feldeffekttransistor (T33) vom Anreicherungstyp mit einem Gate, einer Source und einem Drain, einen p-Kanal Feldeffekttransistor (T35) vom Anreicherungstyp mit einem Gate, einer Source und einem Drain, einen ersten Kondensator (C31b) und/oder einen zweiten Kondensator (C31a) sowie einen weiteren Kondensator (C32) umfasst, dass

- der Kanal (K) des Feldeffektschalttransistors (T36) über den mit der Source (S36) des Feldeffektschalttransistors (T36) verbundenen ersten Kondensator (C31b) mit dem Drain des n-Kanal Feldeffekttransistors (T33), der Source des p-Kanal Feldeffekttransistors (T35) und mit dem Gate (G36) des Feldeffektschalttransistors (T36) verbunden ist und/oder dass der Kanal (K) des Feldeffektschalttransistors (T36) über den mit dem Drain (D36) des Feldeffektschalttransistors (T36) verbundenen zweiten Kondensator (C31a) mit dem Drain des n-Kanal Feldeffekttransistors (T33), der Source des p-Kanal Feldeffekttransistors (T35) und mit dem Gate (G36) des Feldeffektschalttransistors (T36) verbunden ist, dass

- das Drain des n-Kanal Feldeffekttransistors (T33), die Source des p-Kanal Feldeffekttransistors (T35) und das Gate (G36) des Feldeffektschalttransistors (T36) über den weiteren Kondensator (C32) mit einem Betriebspotential (Vdd) verbunden sind, dass

- die Source des n-Kanal Feldeffekttransistors (T33) mit einem Bezugspotential (Vss) verbunden ist, dass

- das Drain des p-Kanal Feldeffekttransistors (T35) mit dem Betriebspotential (Vdd) verbunden ist und dass

- das Gate des n-Kanal Feldeffekttransistors (T33) und das Gate des p-Kanal Feldeffekttransistors (T35) mit einem Eingang (E32) verbunden sind, welchem eine Schaltspannung (on/off) zum Schalten des Feldeffektschalttransistors (T36) zuführbar ist.

8. Regelschaltung für ein Transmission Gate (41, 51, 61, 71, 81) mit einem eine Source (S6, S26), ein Drain (D6, D26), ein zugeordnetes Gate (G6, G26) und einen die Source (S6, S26) und das Drain (D6, D26) verbindenden Kanal (K) aufweisenden n-Kanal Feldeffektschalttransistor (T6, T26) und einem eine Source (S16, S36), ein Drain (D16, D36), ein zugeordnetes Gate (G16, G36) und einen die Source (S16, S36) und das Drain (D16, D36) verbindenden Kanal (K) aufweisenden p-Kanal Feldeffektschalttransistor (T16, T36), wobei die Source (S6, S26) des n-Kanal Feldeffektschalttransistors (T6, T26) und die Source (S16, S36) des p-Kanal Feldeffektschalttransistors (T16, T36) miteinander verbunden sind und wobei das Drain (D6, D26) des n-Kanal Feldeffektschalttransistors (T6, T26) und das Drain des p-Kanal Feldeffektschalttransistors (T16, T36) miteinander verbunden sind,
**dadurch gekennzeichnet, dass**
für wenigstens einen der beiden Feldeffektschalttransistoren (T6, T16, T26, T36) eine Regelschaltung mit einer ersten Schaltungsanordnung (1, 11) und/oder mit einer zweiten Schaltungsanordnung (21, 31) nach einem der vorangegangenen Ansprüche vorgesehen ist.

9. Verfahren zum Ansteuern eines eine Source (S6, S16, S26, S36), ein Drain (D6, D16, D26, D36), ein zugeordnetes Gate (G6, G16, G26, G36) und einen die Source (S6, S16, S26, S36) und das Drain (D6, D16, D26, D36) verbindenden Kanal (K) aufweisenden Feldeffektschalttransistors (T6, T16, T26, T36), bei welchem der Kanalwiderstand (Ron) des Feldeffektschalttransistors (T6, T16, T26, T36) in einem Durchlassbetrieb (on) auf einen im wesentlichen konstanten Widerstandswert geregelt wird,
**dadurch gekennzeichnet, dass**
die Gate-Source-Spannung des Feldeffektschalttransistors (T6, T16, T26, T36) in dem Durchlassbetrieb (on) lediglich dann auf einen im wesentlichen konstanten Spannungswert (Vdd-King) geregelt wird, wenn die Kanalspannung (Kin, Kout) innerhalb eines vorgegebenen Kanalspannungsintervalls ($0 \leq$ Kin, Kout $\leq 1,5$ Volt) liegt und/oder dass die Gate-Source-Spannung des Feldeffektschalttransistors (T6, T16, T26, T36) in dem Durchlassbetrieb auf einen Spannungswert geregelt wird, welcher lediglich um einen vorgegebenen Bruchteil (C22/(C21+C22)) der Kanalspannung (Kin, Kout) schwankt.

Fig. 1

# Fig. 2

Fig. 3

Kin

E1 ← → E11

·41

G6      G16

A1 ←   T6   T16   → A11

Kout

Fig. 4

Supply Saettigung

$V_{ggn} = V_{dd} = 3,3V$

b) tatsächliche Nachregelung

a) Ideale Nachregelung

$V_{ggn} = K_{in} + 1,8V$

$V_{ggn} = V_{dd} - 1,5V = V_{dd} - K_{ing}$

gestellte Gatespannung $V_{ggn}$ (V)

30

20

0    0,5    1,0    1,5

Kanaleingangsspannung $K_{in}$ (V)

EP 1 715 583 A2

EP 1 715 583 A2

Fig. 5

c) PMOS/NMOS-Paar
Transmission Gate mit
Beschaltung nach Fig. 3

a) PMOS/NMOS-Paar-
Transmission Gate

b) PMOS/NMOS-Paar
mit Gate Boosting

Kanalwiderstand bei Durchlaß $R_{on}$ ($\Omega$)

Kanalspannung $K_{in} \approx K_{out}$ (V)

$V_{ss}$

$V_{dd}$

Fig. 6

21

Kin →  E21 ⌒ S26  T26  D26 ⌒ E23 → Kout

C21b ┄┄  G26  C21a ┄┄

Vddd ●  T23  Vggn ● A21  T25  —  Vss

C22

Vdd

off →  E22

Fig. 7

31

Kin →  E31 ⌒ S36  T36  D36 ⌒ E33 → Kout

C31b ┄┄  G36  C31a ┄┄

Vss  T33  Vggp ● A31  T35  Vdd

C32

Vss

on →  E32

Fig. 8

Fig. 9

**Fig. 10**

**Fig 11**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6492860 B1

**In der Beschreibung aufgeführte Nicht-Patentliteratur**

- **ANDREW M. ABO ; PAUL R. GRAY.** A 1.5-V, 10-bit, 14.3MS/s Pipeline Analog-to-Digital Converter. *IEEE Journal of Solid State Circuits,* Mai 1999, vol. 34 (5), 599-666